# FASCICULE DE BREVET EUROPEEN

(11) **EP 1 015 877 B1**
(45) Date de publication et mention de la délivrance du brevet: **03.12.2003**
(21) Numéro de dépôt: 98944016.9
(22) Date de dépôt: 17.09.1998
(51) Int. Cl.: G01N 24/00

(54) **PROCEDE ET EQUIPEMENT POUR LA PREPARATION D'UN GAZ D'HELIUM HYPERPOLARISE A FORTE PRESSION, APPLICATION DUDIT PROCEDE**
VERFAHREN UND VORRICHTUNG ZUR HERSTELLUNG HOCHDRUCK HYPERPOLARISIERTER GASE UND ANWENDUNG DES VERFAHRENS
METHOD AND EQUIPMENT FOR PREPARING A HIGH PRESSURE HYPERPOLARIZED HELIUM GAS, USE OF SAID METHOD

(30) Priorité: 17.09.1997 FR 9711553
(43) Date de publication de la demande: 05.07.2000
(73) Titulaire: CENTRE NATIONAL DE LA RECHERCHE SCIENTIFIQUE, 75016 Paris Cédex (FR)
(72) Inventeur: NACHER, Jean-Pierre, F-75005 Paris (FR); TASTEVIN, Geneviève, F-75005 Paris (FR); DARRASSE, Luc, F-91400 Orsay (FR); GUILLOT, Geneviève, F-91400 Orsay (FR)
(74) Mandataire: Breese, Pierre
(86) Numéro de dépôt international: FR9801998
(87) Numéro de publication internationale: WO99014582

(56) Documents cités:
- WO-A-95/27438
- WO-A-97/29836
- US-A- 5 642 625
- H.-U. KAUCZOR ET AL.: "Normal and Abnormal Pulmonary Ventilation ..." RADIOLOGY, vol. 201, 1996, pages 564-568, XP002066864

## Description

La présente invention concerne le domaine de la préparation d'un gaz d'hélium hyperpolarisé à forte pression.

L'hélium hyperpolarisé est actuellement utilisé en magnétométrie pour la détection et la mesure de faibles champs magnétiques. Une nouvelle application de l'hélium hyperpolarisé est l'exploration in vivo des voies aériennes chez l'homme. Le principe consiste à faire inhaler par le patient un mélange gazeux contenant de l'hélium hyperpolarisé, et à procéder à une imagerie IRM (imagerie par résonance magnétique) pour visualiser la ventilation pulmonaire. L'imagerie peut être effectuée dans un tomographe conventionnel à haut champ (> 1 tesla) ou dans un tomographe à champ plus faible, éventuellement dédié à cet usage. Les inventeurs ont publié un compte-rendu de l'académie des Sciences de PARIS t-230 Série II b, p. 671-700 1997 décrivant quelques aspects de la RMN du gaz ³He dans le poumon vivant, ainsi que les équipements pour la réalisation d'une RMN in vivo. Ce type d'application requiert la production de gaz hyperpolarisé ayant une pression suffisante pour être inhalé (P ≥ 10⁵ Pa).

On connaît par ailleurs dans l'état de la technique plusieurs procédés et installations pour la production d'hélium hyperpolarisé. Le principe général est basé sur le pompage optique laser.

A titre d'exemple le brevet français FR8914894 décrit une cellule de vapeurs atomiques ou moléculaires pour pompage optique selon l'art antérieur. Le gaz de cette cellule est constitué par un mélange d'helium-3 et d'helium-4. Les dispositifs de l'art antérieur ne permettent toutefois que la polarisation de gaz d'hélium à basse pression, qu'il est nécessaire de comprimer à la sortie de la cellule. Or, la compression sans perte de polarisation du gaz d'hélium est délicate et requiert des dispositifs complexes ou onéreux.

L'art antérieur divulgue également deux solutions pour comprimer l'hélium hyperpolarisé : une technique de compression mécanique à l'aide d'un dispositif non dépolarisant, développé dans le groupe du Pr E. OTTEN de l'université de MAINZ et une technique de compression cryogénique décrite dans le brevet français FR9601973 et dans la demande de brevet PCT WO-A-97 29836 sur la base de ce brevet français.

Ce dernier brevet concerne une installation pour la production d'helium-3 polarisé, comportant un réservoir de stockage d'hélium-3 en phase liquide. La production d'hélium-3 avec une telle installation nécessite une phase d'accumulation, une phase de pompage optique et une phase d'évaporation permettant de délivrer de l'hélium-3 polarisé.

L'objet de l'invention est de remédier aux inconvénients et difficultés relative à une compression importante en proposant un procédé évitant l'emploi de compresseurs mécaniques sophistiqués, et permettant de produire de l'hélium hyperpolarisé directement à pression élevée avec un équipement simple.

A cet effet, l'invention concerne tout d'abord un procédé pour la préparation d'un gaz d'hélium hyperpolarisé à forte pression mettant en oeuvre une étape de pompage optique à une longueur d'onde résonante proche de 1083 nanomètres dans un gaz d'hélium formé par l'isotope hélium-3 pur ou d'un mélange d'isotopes hélium-3 et hélium-4 caractérisé en ce que ledit gaz d'hélium est soumis à un champ magnétique de 0,1 à 1 Tesla pendant l'étape de pompage optique, et confiné pendant cette étape de pompage optique à une pression supérieure à 1000 Pa.

La présente invention résout le problème de l'obtention rapide d'hélium fortement polarisé directement sous forme de gaz dense, résultat qui va à l'encontre des idées établies depuis 35 ans sur le pompage optique à 1083 nm dans l'hélium. Elle ne présente aucun des inconvénients des méthodes de pompage optique décrites dans l'état de l'art, mais en combine les avantages en termes de performances. Son rendement et son rythme de production sont meilleurs que ceux de la méthode faisant intervenir une vapeur d'atomes alcalins. Sa pression de fonctionnement élevée simplifie ou rend inutile la compression du gaz polarisé généralement requise à l'issue du pompage optique usuel portant sur l'hélium métastable en champ magnétique faible.

Avantageusement, le gaz d'hélium est confiné dans une cellule de forme générale cylindrique, présentant une face frontale transparente pour l'excitation par un faisceau laser, le champ magnétique étant créé par des bobines électriques, des antennes ou électrodes produisant un champ RF pour la création d'un plasma.

Avantageusement, le gaz d'hélium est confiné dans une cellule de forme générale cylindrique, présentant une face frontale transparente pour l'excitation par un faisceau laser, le champ magnétique étant créé par un aimant permanent, des antennes ou électrodes produisant un champ RF pour la création d'un plasma.

Avantageusement, le gaz d'hélium est confiné dans une cellule de forme générale cylindrique, présentant une face frontale transparente pour l'excitation par un faisceau laser, le champ magnétique est créé au moins en partie par l'imageur.

Selon une variante, le gaz d'hélium est maintenu à une pression de l'ordre de 1000 Pa pendant la phase de pompage optique.

L'invention concerne également un dispositif pour la préparation d'un gaz d'hélium hyperpolarisé à forte pression pour la mise en oeuvre du procédé décrit précédemment du type comprenant une cellule avec un gaz d'hélium formé par l'isotope hélium-3 pur ou d'un mélange d'isotopes hélium-3 et hélium-4 présentant des électrodes (2,3) permettant d'appliquer un champ radiofréquence pour la formation d'un plasma, un laser d'excitation et un polariseur circulaire (5), le gaz d'hélium étant soumis à un champ magnétique de 0,1 à 1 Tesla et maintenu à une pression supérieure à 1000 Pa.

Selon une variante particulière, le dispositif selon l'invention comporte un moyen pour créer un champ magnétique homogène de l'ordre de B=100 mT.

L'invention concerne également une application du procédé de préparation d'hélium hyperpolarisé selon l'invention pour l'exploration in vivo des voies respiratoires par inhalation dudit gaz, et pour l'imagerie par RMN d'un corps en ce que l'on fait inhaler ledit hélium hyperpolarisé.

L'invention sera mieux comprise à la lecture de la description qui suit, se référant à un exemple non limitatif de réalisation d'un dispositif pour la production d'hélium hyperpolarisé se référant aux dessins annexés où :
- la figure 1 représente une vue schématique de d'une installation selon l'invention ,
- la figure 2 représente une vue schématique du générateur de champ magnétique, non représenté en figure 1.

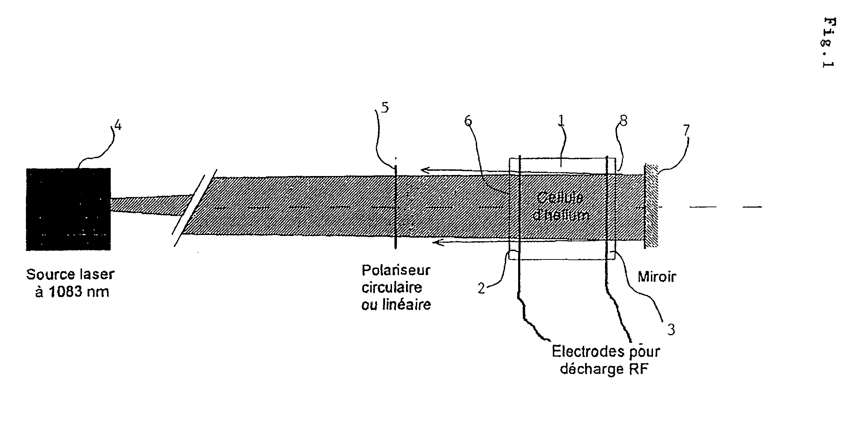

L'installation représentée en figure 1 comprend une cellule (1) contenant du gaz d'hélium. Elle peut être pré-remplie, ou présenter des vannes d'entrée et de sortie permettant d'introduire le gaz d'hélium à la pression souhaitée. Des électrodes (2, 3) permettent d'appliquer un champ radiofréquence pour la formation d'un plasma. Une diode laser (4) d'une puissance de 50 mW constitue la source lumineuse. Un polariseur circulaire (5) est interposé entre la face frontale (6) transparente de la cellule (1) et la diode laser (4). Un miroir (7) placé sur l'axe optique, du coté de la face frontale (8) transparente de la cellule (1) réfléchit dans la cellule (1) la lumière non absorbée. On obtient ainsi une polarisation importante dans 0,1 Tesla dans un gaz à 3200 Pa, comparable à celle obtenue en champ faible dans un gaz à 400 Pa. L'aimantation correspondante, et donc l'amplitude des signaux RMN détectés sont alors bien supérieures). Des polarisations appréciables ont pu être obtenues expérimentalement jusqu'à des pressions supérieures à 13000 Pa.

La présente invention permet de préparer dans un gaz d'hélium une hyperpolarisation importante (polarisation hors d'équilibre, pouvant même être quasi-totale), le gaz ayant une pression forte, pouvant éventuellement aller jusqu'à la pression atmosphérique. L'invention permet d'obtenir une forte polarisation électronique, et en outre une forte polarisation nucléaire si le gaz est de l'hélium-3 pur ou un mélange des isotopes hélium-3 et hélium-4. Elle consiste à effectuer un pompage optique à une longueur d'onde résonante proche de 1083 manomètres dans un gaz d'hélium soumis à un champ magnétique statique de caractéristiques convenables, et à un champ électromagnétique oscillant permettant l'entretien d'un plasma adapté au pompage optique dans un tel champ statique.

Le principe du pompage optique effectué sur la transition atomique de longueur d'onde proche de 1083 nm dans un gaz d'hélium est connu. De manière traditionnelle, une décharge est entretenue pour peupler l'état métastable triplet 2³S₁, en général par un courant radiofréquence induit par des électrodes (2, 3) externes au récipient (1) contenant le gaz, appelé cellule. Un faible champ magnétique (en général de l'ordre du milli-Tesla) est appliqué pour maintenir fixe l'orientation créée par le pompage optique. Dans ces conditions, le plasma ne permet un pompage optique efficace que lorsque la pression du gaz est de l'ordre du millibar (soit 100 Pa).

La polarisation créée par pompage optique résulte de la compétition entre les processus transférant du moment cinétique du faisceau lumineux incident aux variables internes des atomes (polarisations de spin électronique et/ou nucléaire), et les processus de relaxation de ces polarisations vers leur état d'équilibre (où la polarisation est quasi-nulle). L'absorption efficace du faisceau lumineux requiert en particulier le peuplement de l'état métastable des atomes d'hélium par la décharge avec une densité suffisante, mais on ne peut utiliser une décharge intense sans provoquer une relaxation rapide. Deux processus concourent en effet à limiter la densité d'atomes métastables, tout en induisant une relaxation de l'orientation :
- la diffusion atomique des atomes conduit les atomes métastables au contact des parois de la cellule (1), où ils se désexcitent très rapidement en perdant leur orientation ; en régime stationnaire, cette désexcitation est compensée par le transfert (par bombardement électronique dans le plasma) d'atomes de l'état fondamental vers un état généralement très excité. Une cascade radiative (dans laquelle l'orientation éventuelle qu'avait le spin nucléaire avant excitation quitte le gaz sous forme de lumière polarisée) repeuple l'état métastable et compense ainsi les effets de désexcitation au contact des parois. Cette diffusion atomique est d'autant plus rapide que la pression du gaz est faible : le coefficient de diffusion D de l'hélium-3 est proportionnel à la pression et vaut 2000cm²/s à 100 Pa (leur marche au hasard écarte les atomes de leur position d'une distance proportionnelle à la racine carrée du temps écoulé, par exemple 1.4 cm en 1 ms). On sait que pour des pressions de l'ordre de 10 Pa ou inférieures, on ne peut en pratique obtenir par pompage optique une polarisation nucléaire significative dans l'hélium-3. Ceci résulte principalement de la relaxation importante provoquée par la diffusion rapide vers la paroi.
- les collisions inélastiques entre atomes métastables (par exemple les collisions de type Penning conduisant à une ionisation) sont d'autant plus probables que la densité absolue d'atomes métastables est importante. Sous l'effet de ces collisions, deux phénomènes défavorables au pompage optique interviennent lorsque la pression augmente. D'une part, ce sont ces processus qui limitent en pratique la densité d'atomes métastables à 10¹⁰ à 10¹¹ cm⁻³ dans une décharge douce, et cela dans une large mesure indépendamment de la pression du gaz. La proportion d'atomes qui sont dans l'état métastable est donc inversement proportionnelle à la pression (il y a environ 10¹⁷ atomes/cm³ dans un gaz à 250 Pa, et bien sûr 10 fois plus à 2500 Pa) . Or le transfert indirect de polarisation du faisceau lumineux jusqu'aux atomes dans l'état fondamental, qui fait intervenir l'absorption de la lumière par les atomes dans l'état métastable, est d'autant plus lent que leur proportion est faible, c'est à dire d'autant moins efficace que la pression est forte. D'autre part, la probabilité de désexcitation par de telles collisions inélastiques devient plus grande que celle de désexcitation au voisinage de la paroi dès lors que la diffusion est suffisamment ralentie par une pression assez forte ; or les ions moléculaires créés par ces collisions inélastiques ont la propriété d'induire une relaxation supplémentaire de la polarisation nucléaire. On sait que pour des pressions supérieures au millibar (100 Pa), le pompage optique traditionnel est d'autant moins efficace que la pression est forte . Pour des pressions de l'ordre de 10 mbar (1000 Pa) ou supérieures, le ralentissement du pompage et l'accélération de la relaxation qui résultent indirectement des collisions inélastiques empêchent en pratique d'obtenir par pompage optique une polarisation nucléaire significative dans l'hélium-3.

La présente invention consiste principalement à appliquer un champ magnétique d'intensité judicieusement choisie sur le gaz, et à adapter la méthode de génération du plasma et la technique du pompage optique (à la longueur d'onde de 1083 nm) à cette nouvelle situation. L'emploi d'un champ magnétique statique convenable de 0,1 à 1 Tesla présente en particulier deux avantages pour le pompage optique :
- il permet un confinement latéral du plasma, ce qui est une circonstance permettant l'entretien d'une décharge de nature différente de celle que l'on obtient en champ plus faible. Sous réserve d'employer une méthode d'excitation adaptée les caractéristiques de ce plasma sont plus favorables au pompage optique, en particulier aux pressions supérieures à 100 Pa (où la diffusion vers la paroi est suffisamment ralentie)
- il permet un découplage effectif des variables de spin électronique et nucléaire dans la plupart des états excités peuplés par le plasma (l'énergie magnétique Zeeman, qui est de l'ordre de 15 GHz/T, dépasse l'énergie associée au couplage hyperfin, qui est de l'ordre de 1 GHz ou moins pour ces états excités). Cette situation a deux conséquences a priori favorables. D'une part, lors de la cascade radiative évoquée plus haut, le spin nucléaire reste découplé et conserve sa polarisation, la lumière émise n'étant pas polarisée : un champ magnétique assez intense permet ainsi de bloquer l'un des processus de relaxation au sein du plasma. D'autre part, la structure des niveaux atomiques mis en jeu lors de la transition radiative de longueur d'onde proche de 1083 nm est modifiée par l'application d'un champ magnétique assez intense, et les positions et probabilités de transition de ces niveaux peuvent être ajustées pour permettre un pompage optique plus efficace.

L'utilisation judicieuse d'un champ magnétique assez intense permet donc d'effectuer un pompage optique efficace dans l'hélium, et en particulier de construire une forte polarisation nucléaire dans l'état fondamental de l'hélium-3, dans une large gamme de pressions du gaz (même pour des pressions supérieures à 1000 Pa). Un tel champ peut en outre lever la dégénérescence de sous-niveaux d'une quantité supérieure à l'élargissement dû à l'effet Doppler ; cela permet d'exciter sélectivement certains de ces sous-niveaux, en utilisant un ou plusieurs faisceaux de pompage optique dont la ou les longueurs d'onde seront convenablement choisies, avec une grande latitude dans le choix des directions et polarisations des faisceaux.

Outre les éléments habituels permettant le pompage optique de l'hélium, tels qu'ils apparaissent schématiquement sur la figure 1, à savoir une cellule (1) contenant un gaz d'hélium, une source laser de lumière à 1083 nm et moyens de polarisation du faisceau lumineux), un dispositif permettant de créer un champ magnétique suffisamment intense est requis. Il peut s'agir d'un bobinage, ou ensemble d'enroulement, parcouru par un courant continu (aimant résistif), ou d'un aimant permanent constitué d'un assemblage d'éléments faits d'un matériau à aimantation rémanente (ferrite par exemple).

Les caractéristiques importantes du champ sont son intensité B et son homogénéité relative. L'intensité doit être suffisante pour que l'on bénéficie des effets favorables : en pratique un champ de l'ordre de B=100 mT est requis. L'homogénéité doit être suffisamment bonne pour ne pas provoquer une relaxation trop rapide. Cette relaxation résulte de la diffusion des atomes, qui fait que les fluctuations spatiales du champ appliqué provoquent des fluctuations temporelles du champ subi par les atomes ; on sait en général calculer le taux de relaxation résultant 1/T_{δB}, qui est proportionnel à (δB/B)²/P), où P est la pression du gaz et δB/B est l'inhomogénéité relative du champ sur le volume occupé par le gaz.

Dans la méthode traditionnelle de pompage optique de l'hélium, un champ magnétique n'est requis qu'accessoirement, parce qu'en pratique des champs inhomogènes existent sur toute expérience : l'ajout d'un champ homogène a pour seul objet de réduire l'inhomogénéité relative sur le volume du gaz et donc les effets relaxants des inhomogénéités résultant de l'environnement. La valeur de ce champ est sans importance, et on peut fort bien utiliser le champ terrestre par exemple. Pour la présente invention en revanche, l'utilisation d'un champ intense est essentielle, et l'inhomogénéité relative δB/B est en pratique déterminée par la géométrie du dispositif qui crée le champ. Un avantage supplémentaire du pompage optique dans un gaz à forte pression est que la relaxation est ralentie (T_{δB} est proportionnel à P), et que des dispositifs compacts suffisent à engendrer un champ à l'homogénéité suffisante.

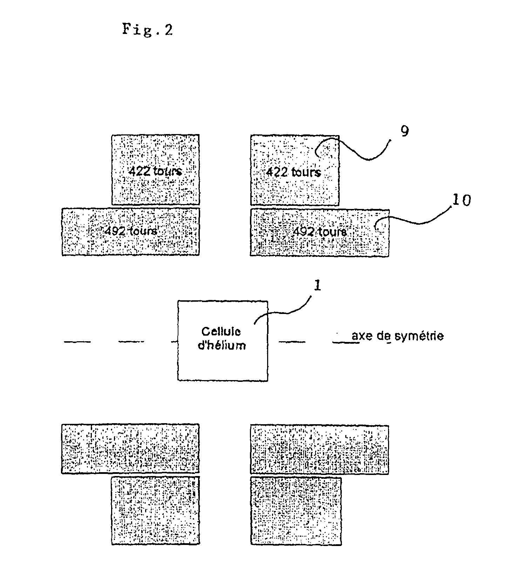

La figure 2 représente un exemple de réalisation d'un dispositif pour la mise en oeuvre l'invention. Il comporte une cellule (1) placée au coeur d'une bobine (9) (10) présentant un diamètre extérieur 25 cm, un diamètre intérieur 10 cm et une longueur de 25 cm, dont l'homogénéité sur un volume de 100 cm³ autour de son centre est suffisante pour que T_{δB} soit assez long pour que l'on puisse effectuer un pompage optique efficace lorsque la pression n'est pas trop faible (T_{δB} de l'ordre de 100 s pour P=100 Pa, 1000 s pour 1000 Pa). Cette source de champ délivre environ 10 mT/A et dissipe 6 W/A².

Un champ magnétique convenable peut également être produit par un imageur IRM : soit au sein d'un appareil à champ faible, soit dans le champ externe d'un appareil à champ intense.

## Revendications

1. Procédé pour la préparation d'un gaz d'hélium hyperpolarisé à forte pression mettant en oeuvre une étape de pompage optique à une longueur d'onde résonante proche de 1083 nanomètres dans un gaz d'hélium formé par l'isotope hélium-3 pur ou d'un mélange d'isotopes hélium-3 et hélium-4 **caractérisé en ce que** ledit gaz d'hélium est soumis à un champ magnétique de 0,1 à 1 Tesla pendant l'étape de pompage optique, et maintenu à une pression supérieure à 1000 Pa.

2. Procédé pour la préparation d'un gaz d'hélium hyperpolarisé à forte pression selon la revendication 1 **caractérisé en ce que** le gaz d'hélium est confiné dans une cellule de forme générale cylindrique, présentant une face frontale transparente pour l'excitation par un faisceau laser, le champ magnétique étant créé par des bobines électriques, des antennes ou des électrodes produisant un champ RF pour la création d'un plasma.

3. Procédé pour la préparation d'un gaz d'hélium hyperpolarisé à forte pression selon la revendication 1 **caractérisé en ce que** le gaz d'hélium est confiné dans une cellule de forme générale cylindrique, présentant une face frontale transparente pour l'excitation par un faisceau laser, le champ magnétique étant créé par un aimant permanent, des antennes ou des électrodes produisant un champ RF pour la création d'un plasma.

4. Procédé pour la préparation d'un gaz d'hélium hyperpolarisé à forte pression selon la revendication 1 **caractérisé en ce que** le gaz d'hélium est confiné dans une cellule de forme générale cylindrique, présentant une face frontale transparente pour l'excitation par un faisceau laser, le champ magnétique est créé au moins en partie par un imageur, IRM.

5. Procédé pour la préparation d'un gaz d'hélium hyperpolarisé à forte pression selon la revendication 1 **caractérisé en ce que** le gaz d'hélium est maintenu à une pression de l'ordre de 1000 Pa pendant la phase de pompage optique.

6. Dispositif pour la préparation d'un gaz d'hélium hyperpolarisé à forte pression pour la mise en oeuvre du procédé selon l'une des revendications 1 à 5 du type comprenant une cellule avec un gaz d'hélium formé par l'isotope hélium-3 pur ou d'un mélange d'isotopes hélium-3 et hélium-4 présentant des électrodes (2,3) permettant d'appliquer un champ radiofréquence pour la formation d'un plasma, un laser d'excitation et un polariseur circulaire (5), le gaz d'hélium étant soumis à un champ magnétique de 0,1 à 1 Tesla et maintenu à une pression supérieure à 1000 Pa.

7. Dispositif pour la préparation d'un gaz d'hélium hyperpolarisé à forte pression selon la revendication 6 **caractérisé en ce qu'**il comporte un moyen pour créer un champ magnétique homogène de l'ordre de B=100 mT.

8. Application du procédé de préparation d'hélium hyperpolarisé selon l'une au moins des revendications 1 à 5 pour l'exploration in vivo des voies respiratoires par inhalation dudit gaz.

9. Application du procédé de préparation d'hélium hyperpolarisé selon l'une au moins des revendications 1 à 5 pour l'imagerie par RMN d'un corps **caractérisé en ce que** l'on fait inhaler ledit hélium hyperpolarisé.

## Patentansprüche

1. Verfahren zur Zubereitung eines hyperpolarisierten Heliumgases mit starkem Gasdruck, welches einen Schritt umfasst, in dem ein optisches Pumpen bei einer resonanzgebenden Wellenlänge von ca. 1083 Manometern in einem aus dem reinen Helium-3 Isotop oder aus einem Gemisch von Helium-3 und Helium-4 Isotopen gebildeten Gas durchgeführt wird, **dadurch gekennzeichnet, dass** das besagte Heliumgas während des Schrittes des optischen Pumpens einem magnetischen Feld von 0,1 bis 1 Tesla ausgesetzt wird und bei einem Gasdruck von über 1000 Pa beibehalten wird.

2. Verfahren zur Zubereitung eines hyperpolarisierten Heliumgases mit starkem Gasdruck nach Anspruch 1, **dadurch gekennzeichnet, dass** das Heliumgas in einer wesentlich zylindrisch ausgebildeten Zelle eingegrenzt ist mit einer durchsichtigen Vorderseite zur Erregung durch einen Laserstrahl, wobei das magnetische Feld von elektrischen Spulen, Antennen oder Elektroden gebildet wird, welche ein RF Feld zur Bildung eines Plasmas herstellen.

3. Verfahren zur Zubereitung eines hyperpolarisierten Heliumgases mit starkem Gasdruck nach Anspruch 1, **dadurch gekennzeichnet, dass** das Heliumgas in einer wesentlich zylindrisch ausgebildeten Zelle eingegrenzt ist mit einer durchsichtigen Vorderseite zur Erregung durch einen Laserstrahl, wobei das magnetische Feld von einem Dauermagnet, Antennen oder Elektroden gebildet wird, welche ein RF Feld zur Bildung eines Plasmas herstellen.

4. Verfahren zur Zubereitung eines hyperpolarisierten Heliumgases mit starkem Gasdruck nach Anspruch 1, **dadurch gekennzeichnet, dass** das Heliumgas in einer wesentlich zylindrisch ausgebildeten Zelle eingegrenzt ist mit einer durchsichtigen Vorderseite zur Erregung durch einen Laserstrahl, wobei das magnetische Feld mindestens teilweise von einem MRI Kernspin-Tomographiegerät gebildet wird.

5. Verfahren zur Zubereitung eines hyperpolarisierten Heliumgases mit starkem Gasdruck nach Anspruch 1, **dadurch gekennzeichnet, dass** während des Schrittes des optischen Pumpens das Heliumgas bei einem Gasdruck von ca. 1000 Pa beibehalten wird.

6. Vorrichtung zur Zubereitung eines hyperpolarisierten Heliumgases zur Durchführung des Verfahrens nach einem der Ansprüche 1 bis 5 eines Typs mit einer Zelle mit einem aus dem reinen Helium-3 Isotop oder einem Gemisch von Helium-3 und Helium-4 Isotopen gebildeten Heliumgas, welche Elektroden (2, 3) aufweist, welche es erlauben, ein Radiofrequenzfeld zur Bildung eines Plasmas aufzudrücken, mit einem Erregungslaser und einem kreisförmigen Polarisierer (5), wobei das Heliumgas einem magnetischen Feld von 0,1 bis 1 Tesla ausgesetzt wird und bei einem Gasdruck von mehr als 1000 Pa beibehalten wird.

7. Vorrichtung zur Zubereitung eines hyperpolarisierten Heliumgases mit starkem Gasdruck nach Anspruch 6, **dadurch gekennzeichnet, dass** sie ein Mittel zur Bildung eines homogenen magnetischen Feldes von ca. B=100 mT aufweist.

8. Anwendung des Verfahrens zur Zubereitung von hyperpolarisiertem Helium nach mindestens einem der Ansprüche 1 bis 5 zur in vivo Erforschung der Atemwege durch Einatmung des besagten Gases.

9. Anwendung des Verfahrens zur Zubereitung von hyperpolarisiertem Helium nach mindestens einem der Ansprüche 1 bis 5 für die Nuklearmagnetresonanztomographie eines Körpers, **dadurch gekennzeichnet, dass** man das besagte hyperpolarisierte Heliumgas einatmen lässt.

## Claims

1. Process for preparation of a hyperpolarised high pressure helium gas using an optical pumping step at a resonant wavelength of close to 1083 nanometers in a helium gas formed from the pure helium-3 isotope or a mix of the helium-3 and helium-4 isotopes, **characterised in that** a magnetic field of 0.1 to 1 Tesla is applied to the said helium gas during the optical pumping step and is held at a pressure of more than 1000 Pa.

2. Process for the preparation of a hyperpolarised high pressure helium gas according to claim 1, **characterised in that** the helium gas is confined in a cell with a generally cylindrical shape, with one transparent front face for excitation by a laser beam, the magnetic field being created by electrical coils, antennas or electrodes producing an RF field for creation of a plasma.

3. Process for preparation of a hyperpolarised high pressure helium gas according to claim 1, **characterised in that** the helium gas is confined in a cell with a generally cylindrical shape with a transparent front face for excitation by a laser beam, the magnetic field being created by permanent magnet, antennas or electrodes producing an RF field for the creation of a plasma.

4. Process for preparation of a hyperpolarised high pressure helium gas according to claim 1, **characterised in that** the helium gas is confined in a cell with a generally cylindrical shape, with one transparent front face for excitation by a laser beam, the magnetic field is created at least partly by an MRI imager.

5. Process for preparation of a high pressure hyperpolarised helium gas according to claim 1, **characterised in that** the helium gas is kept at a pressure of the order of 1000 Pa during the optical pumping phase.

6. Device for preparation of a hyperpolarised high pressure helium gas for implementation of a process according to one of claims 1 to 5, of the type comprising a cell with a helium gas formed by the pure helium-3 isotope or a mix of the helium-3 and helium-4 isotopes with electrodes (2, 3) capable of applying a radio frequency field for the formation of a plasma, an excitation laser and a circular polariser (5), a magnetic field of 0.1 to 1 Tesla being applied to the helium gas that is kept at a pressure of more than 1000 Pa.

7. Device for preparation of a hyperpolarised high pressure helium gas according to claim 6, **characterised in that** it comprises a means of creating a homogeneous magnetic field of the order of B = 100 mT.

8. Application of the process for preparation of hyperpolarised helium according to at least one of claims 1 to 5 for in vivo exploration of the respiratory tracts by inhalation of the said gas.

9. Application of the process for preparation of hyperpolarised helium according to at least one of claims 1 to 5 for MRI imagery of a body, **characterised in that** the said hyperpolarised helium is inhaled.
